# EUROPEAN PATENT APPLICATION

(11) **EP 4 579 719 A1**
(43) Date of publication of application: **02.07.2025**
(21) Application number: 24209157.7
(22) Date of filing: 28.10.2024
(51) Int. Cl.: H01L 21/48, H01L 23/498, H01L 23/538, H01L 25/065

(54) **MICROELECTRONIC ASSEMBLIES INCLUDING CAVITY-LESS ENCAPSULATED DIES**

(30) Priority: 28.12.2023 US 202318398855
(71) Applicant: Intel Corporation, Santa Clara, CA 95054 (US)
(72) Inventor: LIU, Minglu, Chandler, AZ 85248 (US); SHAN, Bohan, Chandler, AZ 85226 (US); LIN, Ziyin, Chandler, AZ 85248 (US); CHEN, Haobo, Chandler, AZ 85249 (US); BAI, Yiqun, Chandler, AZ 85249 (US); ARRINGTON, Kyle Jordan, Gilbert, AZ 85297 (US); WAIMIN, Jose, Gilbert, AZ 85295 (US); CARRAZZONE, Ryan, Chandler, AZ 85226 (US); FENG, Hongxia, Chandler, AZ 85249 (US); PIETAMBARAM, Srinivas Venkata Ramanuja, Chandler, AZ 85249 (US); DUAN, Gang, Chandler, AZ 85248 (US); XU, Dingying, Chandler, AZ 85248 (US); MU, Bin, Tempe, AZ 85284 (US); GUPTA, Mohit, Chandler, AZ 85249 (US); ECTON, Jeremy, Gilbert, AZ 85298 (US); MARIN, Brandon C., Gilbert, AZ 85234 (US); GUO, Xiaoying, Chandler, AZ 85248 (US); DANI, Ashay, Chandler, AZ 85248 (US); KANAOKA, Yosuke, Chandler, AZ 85249 (US)
(74) Representative: Maiwald GmbH

(57) **Abstract**

Microelectronic assemblies, related devices and methods, are disclosed herein. In some embodiments, a microelectronic assembly may include a substrate having a material and conductive pathways through the material, wherein the material includes an organic dielectric material; and a microelectronic component having a first surface and an opposing second surface, wherein the first surface of the microelectronic component is electrically coupled to the conductive pathways in the material by interconnects, wherein the interconnects include solder and are surrounded by a capillary underfill material, and wherein the microelectronic component and the capillary underfill material are surrounded by the material of the substrate.

## Description

### Background

Integrated circuit (IC) devices (e.g., dies) are typically coupled together in a multi-die IC package to integrate features or functionality and to facilitate connections to other components, such as package substrates. IC packages may include an embedded multi-die interconnect bridge (EMIB) for coupling two or more IC dies.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1A is a side, cross-sectional view of an example microelectronic assembly, in accordance with various embodiments.
FIG. 1B is a side, cross-sectional view of another example microelectronic assembly, in accordance with various embodiments.
FIG. 2 is a side, cross-sectional view of an example microelectronic assembly, in accordance with various embodiments.
FIG. 3 is a side, cross-sectional view of an example microelectronic assembly, in accordance with various embodiments.
FIGS. 4A-4I are side, cross-sectional views of various stages in an example process for manufacturing the microelectronic assembly of FIG. 1A, in accordance with various embodiments.
FIGS. 5A-5F are side, cross-sectional views of various stages in an example process for manufacturing a microelectronic assembly similar to FIG. 2, in accordance with various embodiments.
FIGS. 6A-6E are side, cross-sectional views of various stages in an example process for manufacturing the microelectronic assembly of FIG. 3, in accordance with various embodiments.
FIG. 7 is a top view of a wafer and dies that may be included in a microelectronic assembly, in accordance with any of the embodiments disclosed herein.
FIG. 8 is a cross-sectional side view of an IC device that may be included in a microelectronic assembly, in accordance with any of the embodiments disclosed herein.
FIG. 9 is a cross-sectional side view of an IC device assembly that may include a microelectronic assembly, in accordance with any of the embodiments disclosed herein.
FIG. 10 is a block diagram of an example electrical device that may include a microelectronic assembly, in accordance with any of the embodiments disclosed herein.

### Detailed Description

### Overview

Communicating large numbers of signals between two or more dies in a multi-die IC package is challenging due to the increasingly small size of such dies and increased use of stacking dies. Multi-die IC packaging typically requires increased die segregation, additional power delivery requirements, and stricter routing and alignment tolerances throughout the package. The greater number of embedded dies and smaller size of embedded dies (i.e., dies, passives, etc.) vastly increases manufacturing complexity as well as routing complexity. For example, a multi-die IC package may include encapsulated bridge dies (e.g., dies embedded within a substrate, such as EMIBs) and top dies (e.g., dies coupled to the embedded die at a surface of the substrate). Typically, a multi-die IC package includes a cavity formed in the substrate and the bridge die is at least partially embedded within the cavity and surrounded by a dielectric material, such as a buildup material, or a mold material, such as an epoxy-based resin with fillers. A bridge die may be electrically coupled to conductive contacts at a bottom surface of the cavity by solder bumps. Such interconnects typically utilize a non-conductive film (NCF) at a bottom surface of the bridge die to function as an underfill material that flows around and between the solder bumps and subsequently cures. An NCF material generally includes inorganic fillers to improve the mechanical and reliability properties of the material, however, these inorganic fillers are often trapped at the solder to conductive contact interface during the bonding and solder reflow process, which prevents the solder bumps from forming interconnects and is likely to create malfunctions, failures, and other reliability issues in multi-die IC packages during use. Further, the use of an NCF material requires a surface finish material, such as gold, on the conductive contacts, is volatile (e.g., has a short pot life between lamination on the bottom surface of the bridge die to solder bump bonding), which limits manufacturing timeframes, and involves a complicated prep process to lamination bridge dies at the wafer level and to, subsequently, singulate. Various ones of the embodiments disclosed herein may help reduce the cost and complexity associated with assembling multi-die IC packages relative to conventional approaches by encapsulating a bridge die in a substrate without forming a cavity and without using an NCF material as the underfill material around and between the solder interconnects.

Accordingly, microelectronic assemblies, related devices and methods, are disclosed herein. Microelectronic assemblies, related devices and methods, are disclosed herein. In some embodiments, a microelectronic assembly may include a substrate having a material and conductive pathways through the material, wherein the material includes an organic dielectric material or an organic buildup material; and a microelectronic component having a first surface and an opposing second surface, wherein the first surface of the microelectronic component is electrically coupled to the conductive pathways in the material by interconnects, wherein the interconnects include solder and are surrounded by a capillary underfill material, and wherein the microelectronic component and the capillary underfill material are surrounded by the material of the substrate.

In some embodiments, a microelectronic assembly may include a first layer of a substrate including a first material and first conductive pathways through the first material, the first material including a dielectric material; a second layer of the substrate on the first layer, the second layer including a second material and second conductive pathways through the second material, the second material including a mold underfill material; and a microelectronic component having a first surface and an opposing second surface, wherein the microelectronic component is in the second layer of the substrate, wherein the first surface of the microelectronic component is electrically coupled to the first conductive pathways in the first layer by interconnects including solder, wherein the microelectronic component and the interconnects are surrounded by the second material, and wherein the first conductive pathways include conductive vias and conductive traces and the second conductive pathways include conductive vias.

In some embodiments, a microelectronic assembly may include a first layer of a substrate including a material and first conductive pathways through the material, the material including a dielectric material; a second layer of the substrate on the first layer, the second layer including the material and second conductive pathways through the material; and a microelectronic component having a first surface and an opposing second surface, wherein the microelectronic component is in the second layer of the substrate, wherein the first surface of the microelectronic component is electrically coupled to the first conductive pathways in the first layer by interconnects, wherein the interconnects include solder and are surrounded by a capillary underfill material, wherein the microelectronic component and the capillary underfill material are surrounded by the material, and wherein the first conductive pathways include conductive vias and conductive traces and the second conductive pathways include conductive vias.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" (IC) means a circuit that is integrated into a monolithic semiconductor or analogous material.

In some embodiments, the IC dies disclosed herein may comprise substantially monocrystalline semiconductors, such as silicon or germanium, as a base material (e.g., substrate, body) on which integrated circuits are fabricated with traditional semiconductor processing methods. The semiconductor base material may include, for example, N-type or P-type materials. Dies may include, for example, a crystalline base material formed using a bulk silicon (or other bulk semiconductor material) or a silicon-on-insulator (SOI) structure. In some other embodiments, the base material of one or more of the IC dies may comprise alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may comprise compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may comprise an intrinsic IV or III-V semiconductor material or alloy, not intentionally doped with any electrically active impurity; in alternate embodiments, nominal impurity dopant levels may be present. In still other embodiments, dies may comprise a non-crystalline material, such as polymers; for example, the base material may comprise silica-filled epoxy. In other embodiments, the base material may comprise high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of I/O functions, arithmetic operations, pipelining of data, etc.).

In another example, the terms "package" and "IC package" are synonymous, as are the terms "die," "IC," and "IC die." Note that the terms "microelectronic component," "chip," "chiplet," "die," "IC," and "IC die," and similar variations may be used interchangeably herein. The terms "interconnect component," "bridge die," "interconnect bridge," and "interconnect die," and similar variations may be used interchangeably herein.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. A dielectric material may include any suitable dielectric material commonly used in semiconductor manufacture, such as silicon and one or more of oxygen, nitrogen, hydrogen, and carbon (e.g., in the form of silicon oxide, silicon nitride, silicon oxynitride, or silicon carbon nitride); a polyimide material; or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., MOSFETs. In many embodiments, an FET is a four-terminal device. In silicon-on-insulator, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides, including optical fiber, optical splitters, optical combiners, optical couplers, and optical vias.

As used herein, the term "optical element" includes arrangements of forms fabricated in ICs to receive, transform and/or transmit optical signals as described herein. It may include optical conductors such as waveguides, grating coupler, electromagnetic radiation sources such as lasers, and electro-optical devices such as photodetectors.

The term "waveguide" refers to any structure that acts to confine and guide the propagation of light from one location to another location typically through a substrate material such as silicon or glass. In various examples, waveguides can be formed from silicon, doped silicon, silicon nitride, glasses such as silica (e.g., silicon dioxide or SiO₂), borosilicate (e.g., 70-80 wt% SiOj, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing (e.g., a laser written waveguide). Waveguides formed in situ may have lower loss characteristics.

The term "conductive trace" may be used to describe an electrically conductive element isolated by an insulating material. Within IC dies, such insulating material comprises interlayer low-k dielectric that is provided within the IC die. Within package substrates, and printed circuit boards (PCBs) such insulating material comprises organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/- 5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

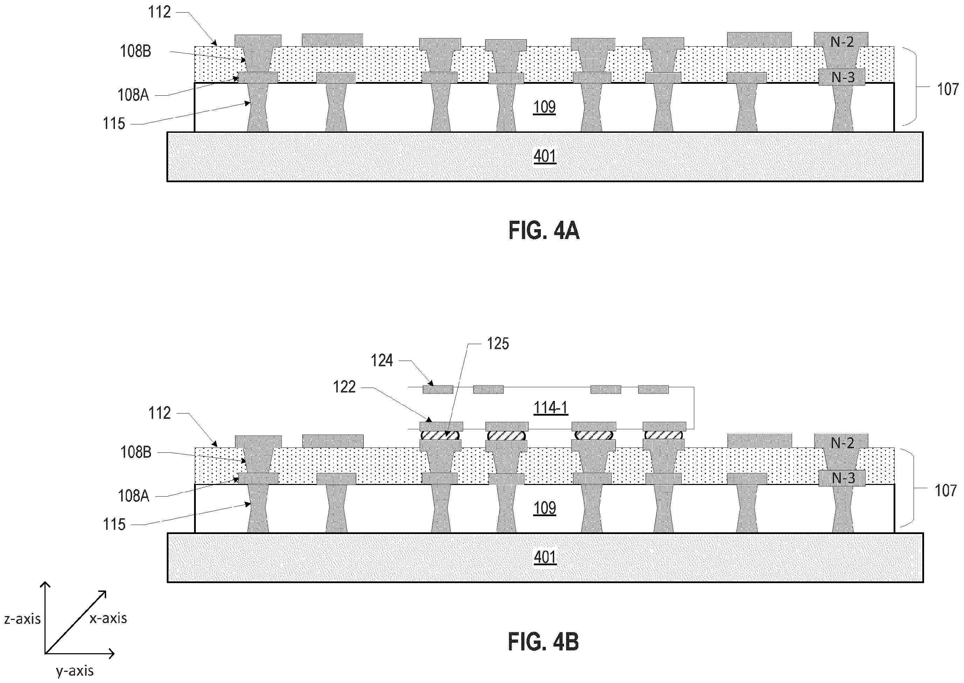

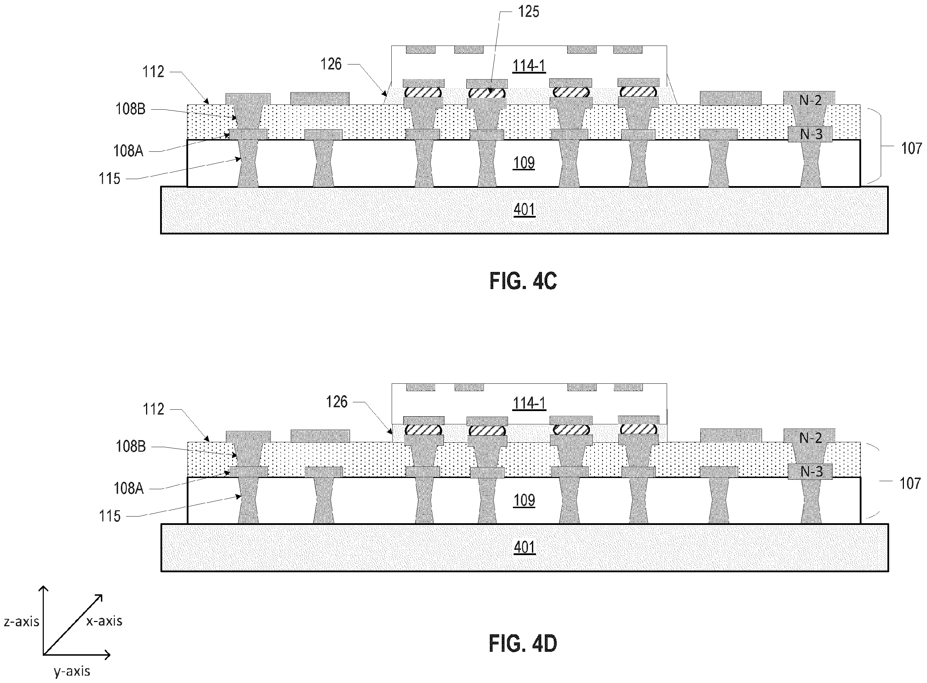

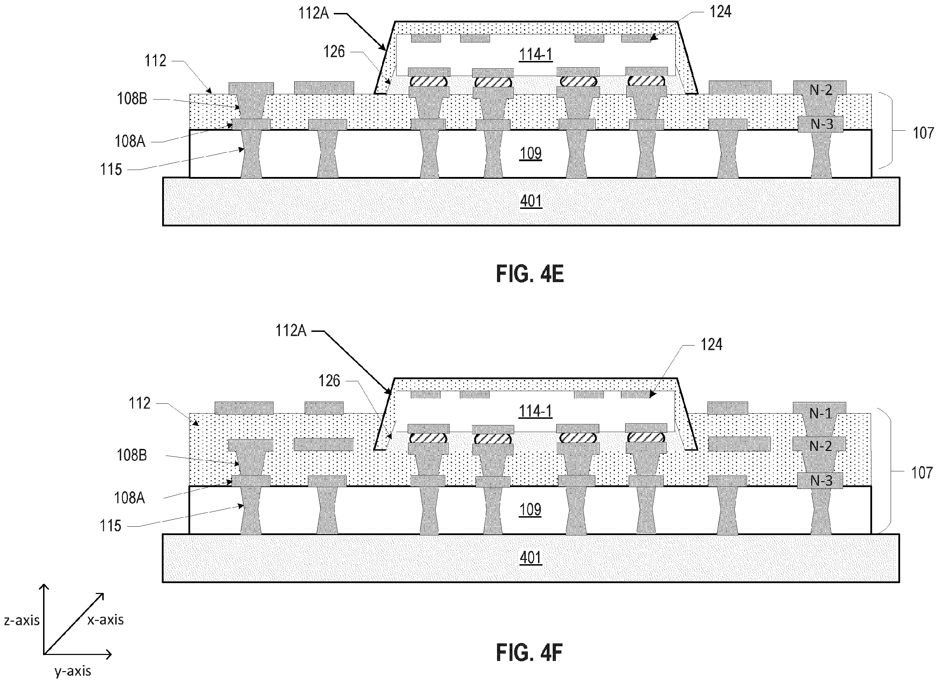

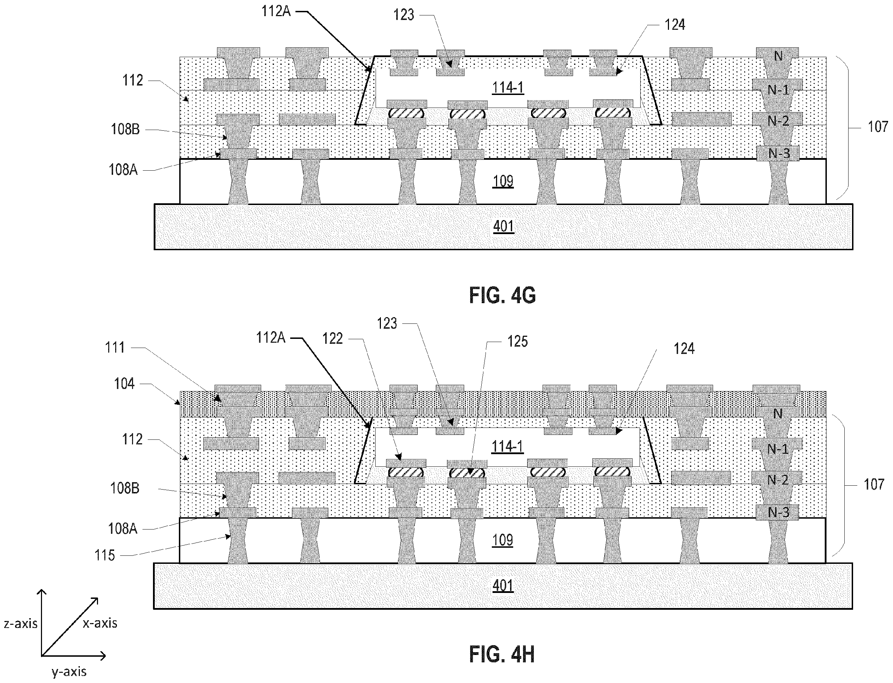

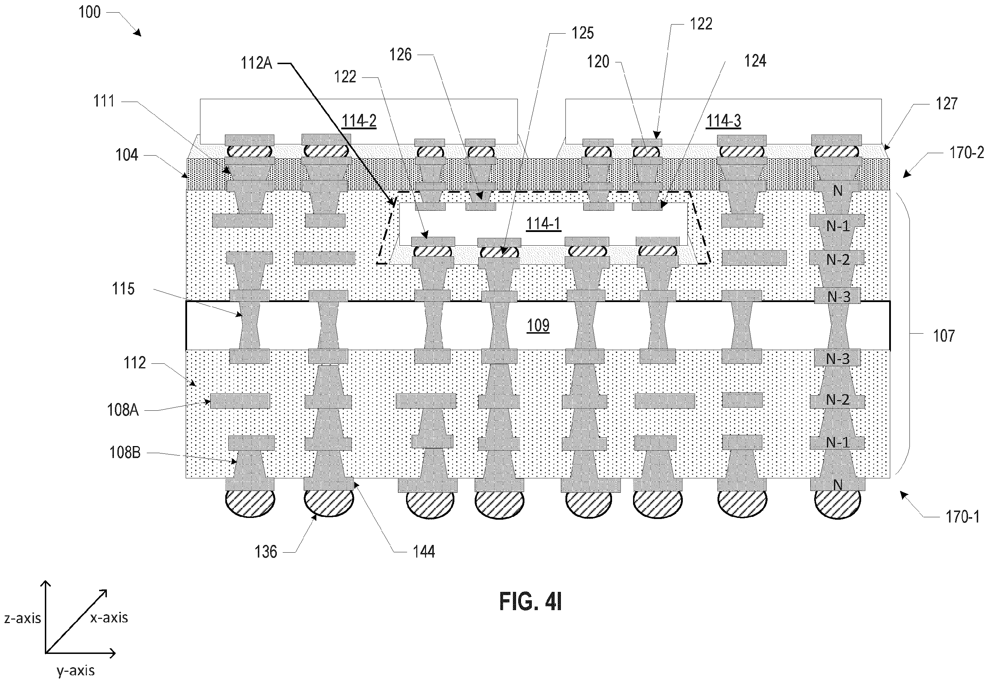

For convenience, if a collection of drawings designated with different letters are present (e.g., FIGS. 4A-4I), such a collection may be referred to herein without the letters (e.g., as "FIG. 4"). Similarly, if a collection of reference numerals designated with different numerals or letters are present (e.g., 114-1, 114-2, 114-3, etc.), such a collection may be referred to herein without the numerals or letters (e.g., as "114").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

### Example embodiments

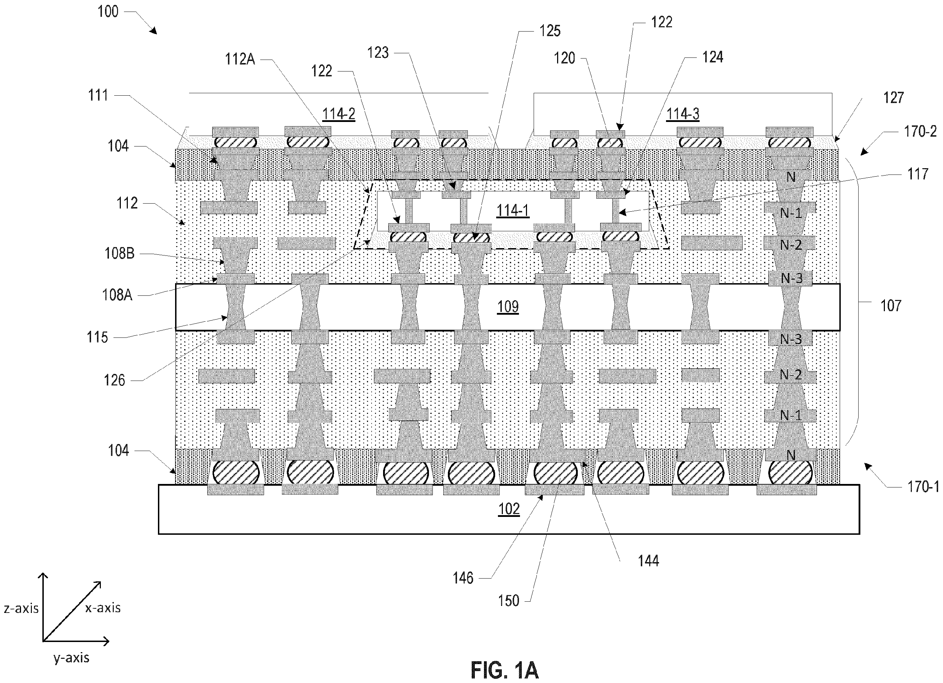

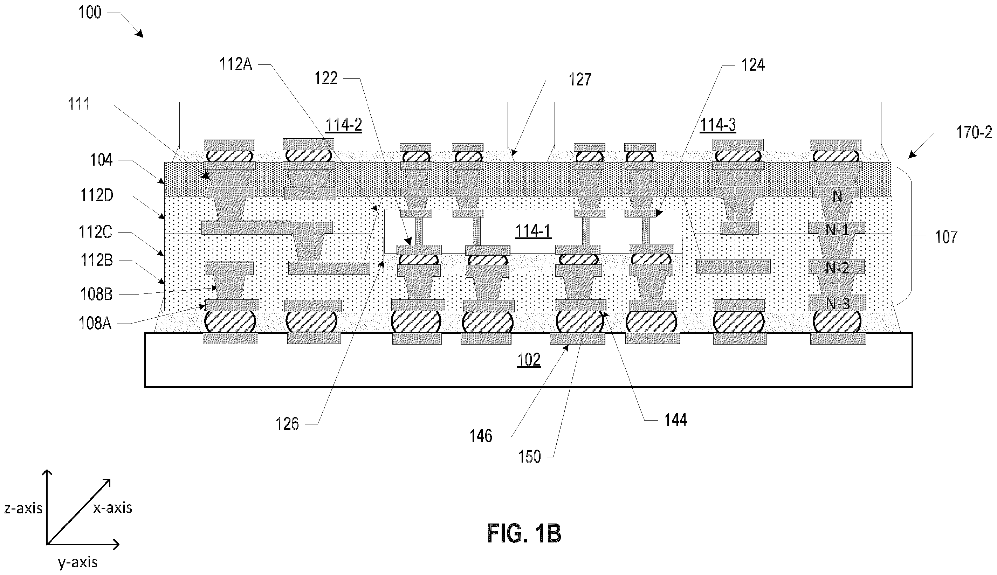

FIG. 1A is a side, cross-sectional view of an example microelectronic assembly, in accordance with various embodiments. As shown in FIG. 1A, the microelectronic assembly 100 may include a die 114-1 within a substrate 107, where the die 114-1 is not embedded within a cavity formed in the substrate 107 instead the die 114-1 is conformally coated with a dielectric material 112A (e.g., as indicated by the dotted lines). In particular, as shown in FIG. 1B, the substrate 107 may include a die 114-1 electrically coupled by interconnects 125 to conductive pathways 108 in the substrate 107, the interconnects 125 are surrounded by an underfill material 126, and, subsequently, the die 114-1 and the interconnects 125 are surrounded by a dielectric material 112A. The substrate 107 may include a dielectric material 112 and a conductive material 108 (e.g., lines/traces/pads/contacts (e.g., 108A) and vias (e.g., 108B), as shown) around the die 114-1 (e.g., above, below, and along sides of the die 114-1) where the conductive material 108 is arranged in the dielectric material 112 to provide conductive pathways horizontally (e.g., x-direction and y-direction) and vertically (e.g., z-direction) through the substrate 107. As shown in FIG. 1B, the dielectric material 112A may be formed over and around the die 114-1, and subsequently, the dielectric material 112 of the substrate 107 may be formed in layers around the die 114-1 (e.g., at least a first dielectric material layer 112B, a second dielectric material layer 112C, and a third dielectric material layer 112D), and, as shown in FIG. 1A, the layers of dielectric material 112 (e.g., layers of dielectric material 112A, 112B, 112C, and 112D) may not be distinguishable after formation. In some embodiments, the dielectric material 112 may include an organic dielectric material, such as an organic buildup film, a polyimide, a polyamide, a polyacrylate, an epoxy, a polybenzoxazole, a polyphenyl ether, a polysiloxane, a polynorbornene, or a polyolefin. In some embodiments, the organic dielctric material is photoimageable, such as a photoimageable dielectric (PID), a liquid photoimageable polymer, or a dry film photoimageable polymer. In some embodiments, the dielectric material 112 may include a ceramic, an epoxy film having filler particles therein, glass, an inorganic material, or combinations of organic and inorganic materials, for example. In some embodiments, a dielectric material 112A may include a liquid form of a same dielectric material 112 that may be deposited to conformally cover the die 114-1. A dielectric material 112A may include a liquid form of the dielectric material 112. In some embodiments, a dielectric material 112A is a same material as the dielectric material 112. In some embodiments, a dielectric material 112A is a different material than the dielectric material 112. In some embodiments, the conductive material 108 may include a metal (e.g., copper). In some embodiments, the substrate 107 may include layers of dielectric material 112/conductive material 108, with lines/traces/pads/contacts (e.g., 108A) of conductive material 108 in one layer electrically coupled to lines/traces/pads/contacts (e.g., 108A) of conductive material 108 in an adjacent layer by vias (e.g., 108B) of the conductive material 108 extending through the dielectric material 112. Conductive elements 108A may be referred to herein as "conductive lines," "conductive traces," "conductive pads," or "conductive contacts." A substrate 107 including such layers may be formed using any suitable technique, for example, as described below with reference to FIG. 4.

Returning to FIG. 1A, the substrate 107 may include a first surface 170-1 (e.g., a bottom surface) and an opposing second surface 170-2 (e.g., a top surface). The microelectronic assembly 100 may further include a material 104 at a top surface 170-2 of the substrate 107 and/or at the bottom surface 170-1 of the substrate 107. A material 104 may include a solder resist material, such as an epoxy and acrylic copolymer. In some embodiments, a thickness (e.g., a z-height) of the material 104 may be between 2 microns and 100 microns (e.g., between 2 microns and 20 microns). The material 104 at the top and/or bottom surfaces 170-1, 170-2 of the substrate 107 may function as an overmolding layer and a surface insulation layer (e.g., a passivation layer) that may provide surface electrical insulation and may be compatible with solder-based or non-solder based interconnects, as appropriate.

As shown in FIG. 1A, the substrate 107 may include a core 109 with through-core vias 115 and a dielectric material 112 and a conductive material 108 may be present below the core 109. In some embodiments, as shown in FIG. 1B, a substrate 107 may not include a core 109 and/or dielectric layers 112 below the core 109. The core 109 may be formed of any suitable material, including glass, a fiber-reinforced epoxy, an organic dielectric material, such as an epoxy, or a phenolic resin or polyimide resin reinforced with glass, aramid, or nylon.

A substrate 107 may include N layers of conductive material 108, where N is an integer greater than or equal to one; in the accompanying drawings, the layers are labeled in descending order from the respective first and second surfaces 170-1, 170-2 of the substrate 107 (e.g., layer N, layer N-1, layer N-2, layer N-3, etc.). In particular, as shown in FIG. 1, a substrate 107 may include four metal layers (e.g., N, N-1, N-2, and N-3) on the top and bottom surfaces of the core 109. Conductive vias 111 through the material 104 at the top surface 170-2 of the substrate 107 may be coupled to conductive contacts 108A in the N metal layer of the substrate 107 (e.g., at a top surface of the dielectric material 112).

The die 114-1 may be surrounded by a dielectric material 112 of the substrate 107. The die 114-1 may include a bottom surface (e.g., the surface facing towards the first surface 170-1) with conductive contacts 122, an opposing top surface (e.g., the surface facing towards the second surface 170-2) with conductive contacts 124, and through-silicon vias (TSVs) 117 coupling respective conductive contacts 122, 124. The die 114-1 may be electrically coupled by an interconnect 125 to a conductive trace 108A in a metal layer N-2 of the substrate 107 that is beneath a bottom of the die 114-1. In some embodiments, interconnect 125 includes solder, as shown. In some embodiments, a pitch of the conductive contacts 122 on the first die 114-1 maybe between 25 microns and 250 microns. In some embodiments, a pitch of the conductive contacts 124 on the first die 114-1 may be between 25 microns and 250 microns.

The microelectronic assembly 100 of FIG. 1A may also include an underfill material 126. In some embodiments, the underfill material 126 may extend between the bottom surface of the die 114-1 and the dielectric material 112 of layer N-2 of the substrate 107 around the associated interconnects 125. The underfill material 126 may be an insulating material that flows between and around interconnects 125 and, subsequently, cures or solidifies to encapsulate interconnects 125. An underfill material 126 may include any suitable material, such as a capillary underfill, a liquid dielectric material, an epoxy-based underfill material with fillers. In some embodiments, the underfill material 126 does not include an NCF. In some embodiments, as shown in FIG. 1A, the underfill material 126 may have a trapezoidal shape (e.g., angled outwards on the sides towards the bottom surface). In some embodiments, as shown in FIG. 1B, the underfill material 126 may have a rectangular shape (e.g., having straight sides, not angled sides), where the outer fillets of the underfill material 126 is removed, for example, by an excimer laser.

The die 114-2, 114-3 may include a set of conductive contacts 122 on the bottom surface of the die (e.g., the surface facing towards the first surface 170-1). The die 114-1 may be electrically coupled to die 114-2, 114-3 by interconnects 120 at a second surface 170-2. In particular, conductive contacts 124 on a top surface of the die 114-1 may be coupled to conductive contacts 122 on a bottom surface of die 114-2, 114-3 by interconnects 120, by conductive vias 111 through the material 104, and by conductive vias 123 through the dielectric material 112 at a top surface of the die 114-1. The conductive contacts 122 on a bottom surface of the die 114-2, 114-3 may further be electrically coupled to the conductive material 108 in the substrate 107 by interconnects 120 and by conductive vias 111 through the material 104 to conductive pad 108A in the N metal layer adjacent the top surface 170-2 of the substrate 107.

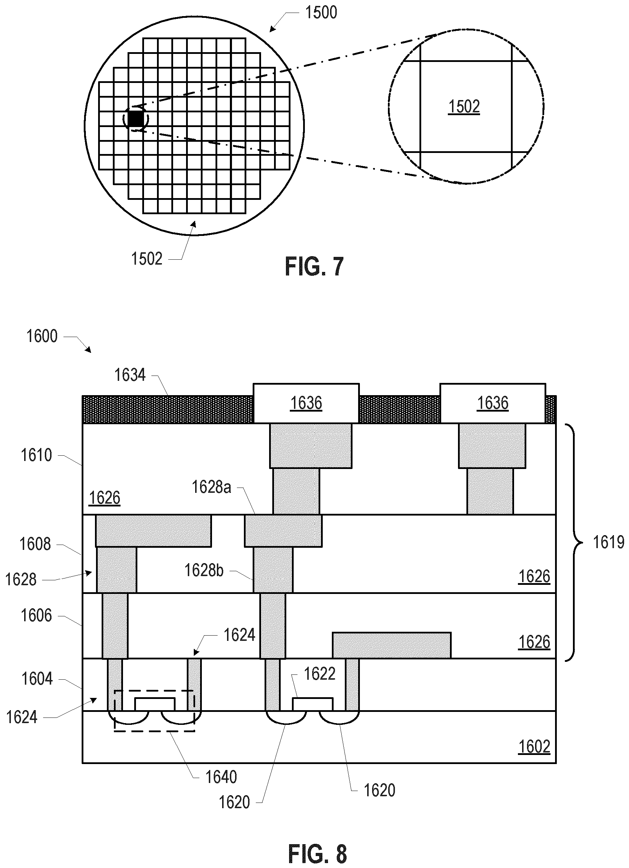

The die 114 may include other conductive pathways (e.g., including lines and vias) and/or to other circuitry (not shown) coupled to the respective conductive contacts (e.g., conductive contacts 122, 124) on the surface of the die 114. The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). Example structures that may be included in the dies 114 disclosed herein are discussed below with reference to FIG. 8. The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked).

In some embodiments, the die 114 may include conductive pathways to route power, ground, and/or signals to/from other dies 114 included in the microelectronic assembly 100. For example, the die 114-1 may include TSVs, including a conductive material via, such as a metal via, isolated from the surrounding silicon or other semiconductor material by a barrier oxide), or other conductive pathways through which power, ground, and/or signals may be transmitted between a circuit board 102 and one or more dies 114 "on top" of the die 114-1 (e.g., in the embodiment of FIG. 1, the die 114-2, 114-3). In some embodiments, the die 114-1 may not route power and/or ground to the die 114-2; 114-3, instead, the die 114-2, 114-3 may couple directly to power and/or ground lines in the circuit board 102 by interconnects 150, conductive material 108, and interconnects 120 that electrically couple to the N metal layer in the substrate 107. In some embodiments, the die 114-1 may be thicker than the die 114-2, 114-3. In some embodiments, the die 114-1 may be thinner than the die 114-2, 114-3. In some embodiments, the die 114-1 may be a memory device (e.g., as described below with reference to the die 1502 of FIG. 7), or a high frequency serializer and deserializer (SerDes), such as a Peripheral Component Interconnect (PCI) express. In some embodiments, the die 114-1 may be a processing die, a radio frequency chip, a power converter, a network processor, a workload accelerator, a voltage regulator die, or a security encryptor. In some embodiments, the die 114-2, 114-3 may be a processing die, a radio frequency chip, a power converter, a network processor, a workload accelerator, a voltage regulator die, or a security encryptor.

Although a particular number and arrangement of layers of dielectric material 112/conductive material 108 are shown in various ones of the accompanying figures, these particular numbers and arrangements are simply illustrative, and any desired number and arrangement of dielectric material 112/conductive material 108 may be used. Further, although a particular number of layers are shown in the substrate 107 (e.g., four layers), these layers may represent only a portion of the substrate 107, for example, further layers may be present (e.g., layers N-4, N-5, N-6, etc.).

The substrate 107 may be coupled to a circuit board 102 by interconnects 150. In particular, the top surface of the circuit board 102 may include a set of conductive contacts 146. Conductive contacts 144 on the bottom surface of the substrate 107 may be electrically and mechanically coupled to the conductive contacts 146 on the top surface of the circuit board 102 by the interconnects 150. Interconnects 150 may include any suitable interconnects, including solder balls for a ball grid array arrangement (as shown), pins in a pin grid array arrangement or lands in a land grid array arrangement. In some embodiments, the interconnects 150 may not couple the substrate 107 to a circuit board 102, but may instead couple the substrate 107 to another IC package, an interposer, or any other suitable component. The circuit board 102 may include an insulating material (e.g., a dielectric material formed in multiple layers, as known in the art) and one or more conductive pathways to route power, ground, and signals through the dielectric material (e.g., including conductive traces and/or conductive vias, as shown). The circuit board may be a motherboard, for example. When the circuit board 102 is formed using standard printed circuit board (PCB) processes, the circuit board 102 may include FR-4, and the conductive pathways in the circuit board 102 may be formed by patterned sheets of copper separated by build-up layers of the FR-4. The conductive pathways in the circuit board 102 may be bordered by liner materials, such as adhesion liners and/or barrier liners, as suitable. Any method known in the art for fabrication of the circuit board 102 may be used, and for the sake of brevity, such methods will not be discussed in further detail herein.

In some embodiments, the circuit board 102 may be a lower density medium and the die 114 may be a higher density medium or have an area with a higher density medium. As used herein, the term "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive build-up process with advanced lithography (with small vertical interconnect features formed by advanced laser or lithography processes), while a lower density medium may be a PCB manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual damascene process. In some embodiments, additional dies may be disposed on the top surface of the die 114-2. In some embodiments, additional components may be disposed on the top surface of the die 114-2, 114-3. Additional passive components, such as surface-mount resistors, capacitors, and/or inductors, may be disposed on the top surface or the bottom surface of the circuit board 102.

The microelectronic assembly 100 of FIG. 1A may also include an underfill material 127. In some embodiments, the underfill material 127 may extend between the die 114-2, 114-3 and the top surface 170-2 of the substrate 107 around the associated interconnects 120. The underfill material 127 may be an insulating material, such as an appropriate epoxy material. In some embodiments, the underfill material 127 may include a capillary underfill, NCF, or molded underfill. In some embodiments, the underfill material 127 may include an epoxy flux that assists with soldering the die 114-2 to the substrate 107 when forming the interconnects 120, and then polymerizes and encapsulates the interconnects 120. The underfill material 127 may be selected to have a coefficient of thermal expansion (CTE) that may mitigate or minimize the stress between the substrate 107 and the die 114-2 arising from uneven thermal expansion in the microelectronic assembly 100. In some embodiments, the CTE of the underfill material 127 may have a value that is intermediate to the CTE of the substrate 107 (e.g., the CTE of the dielectric material 112 of the substrate 107) and a CTE of the dies 114.

The interconnects (e.g., interconnects 120, 125, 150) disclosed herein may take any suitable form. The interconnects 120 may have a finer pitch than the interconnects 150 in a microelectronic assembly. In some embodiments, a set of interconnects may include solder (e.g., solder bumps or balls that are subject to a thermal reflow to form the interconnects), for example, as shown in FIG. 1A, the interconnects 120 may include solder between a conductive contact 122 on a bottom surface of the die 114-2, 114-3 and a conductive via 111 on a top surface of the substrate 107, and the interconnects 150 may include solder between a conductive contact 144 on a bottom surface of the substrate 107 and a conductive contact 146 on a top surface of the circuit board 102. In some embodiments, a set of interconnects (e.g., interconnects 120, 125) may include small conductive bumps (e.g., copper bumps). In some embodiments, a set of interconnects may include an anisotropic conductive material, such as an anisotropic conductive film or an anisotropic conductive paste. An anisotropic conductive material may include conductive materials dispersed in a non-conductive material.

In some embodiments, interconnects (e.g., interconnects between conductive vias 123 and conductive contacts 124 on a top surface of die 114-1) in a microelectronic assembly 100 may be metal-to-metal interconnects (e.g., copper-to-copper interconnects, or plated interconnects). In such embodiments, the interconnect may be bonded together (e.g., under elevated pressure and/or temperature) without the use of intervening solder or an anisotropic conductive material. Any of the conductive contacts disclosed herein (e.g., the conductive contacts 122, 124, 144, and/or 146) may include bond pads, solder bumps, conductive posts, or any other suitable conductive contact, for example. In some embodiments, interconnects 120, 125 in a microelectronic assembly 100 may be solder interconnects that include a solder with a higher melting point than a solder included in some or all of the interconnects 150. For example, when the interconnects 120, 125 in a microelectronic assembly 100 are formed before the interconnects 150 are formed, solder-based interconnects 120, 125 may use a higher-temperature solder (e.g., with a melting point above 200 degrees Celsius), while the interconnects 150 may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth) or tin, silver, and bismuth. In some embodiments, a lower-temperature solder may include indium, indium and tin, or gallium.

In some embodiments, the interconnects 125 disclosed herein may have a pitch between 25 microns and 250 microns. In some embodiments, the interconnects 150 disclosed herein may have a pitch between 55 microns and 2000 microns, while the interconnects 120 disclosed herein may have a pitch between 25 microns and 250 microns for die 114-2 to die 114-1 interconnects and may have a pitch between 25 microns and 250 microns for die 114-2 to substrate 107 interconnects (e.g., to N metal layer).

Although FIG. 1A depicts a microelectronic assembly 100 having a substrate with a particular number of dies 114 and conductive pathways 108, this number and arrangement are simply illustrative, and a microelectronic assembly 100 may include any desired number and arrangement of dies 114. Although FIG. 1A shows the die 114-1 as a double-sided die and the die 114-2, 114-3 as a single-sided die, the die 114-2, 114-3 may be double-sided dies and the dies 114 may be a single-pitch die or a mixed-pitch die. In this context, a double-sided die refers to a die that has connections on both surfaces. In some embodiments, a double-sided die may include through TSVs to form connections on both surfaces. The active surface of a double-sided die, which is the surface containing one or more active devices and a majority of interconnects, may face either direction depending on the design and electrical requirements.

Many of the elements of the microelectronic assembly 100 of FIG. 1A are included in other ones of the accompanying drawings; the discussion of these elements is not repeated when discussing these drawings, and any of these elements may take any of the forms disclosed herein. Further, a number of elements are illustrated in FIG. 1A as included in the microelectronic assembly 100, but a number of these elements may not be present in a microelectronic assembly 100. For example, in various embodiments, the core 109, the underfill material 127, and the circuit board 102 may not be included. In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

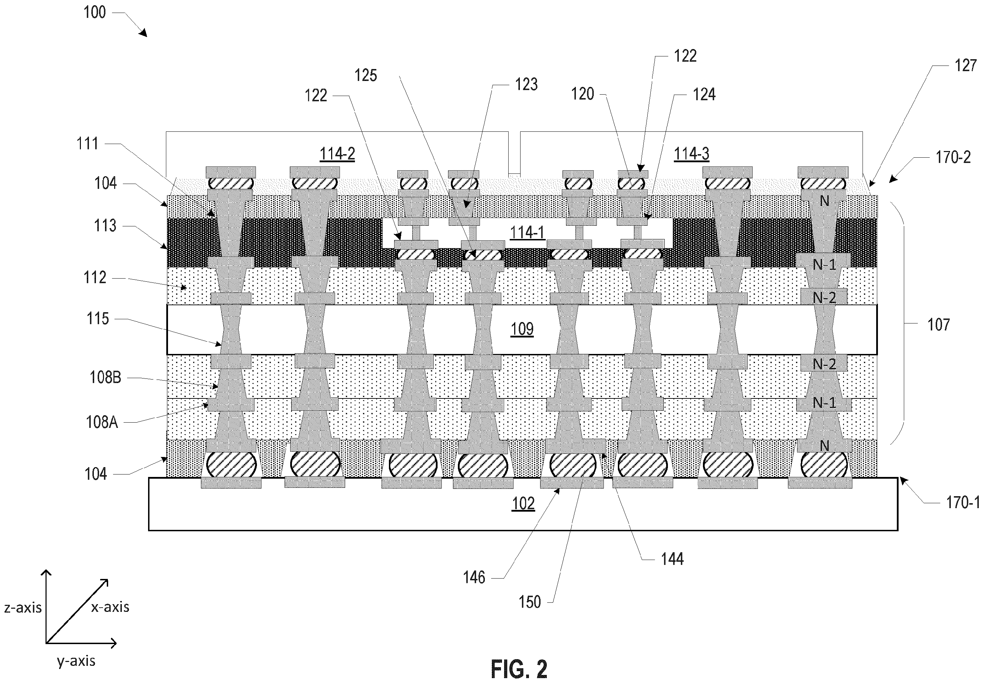

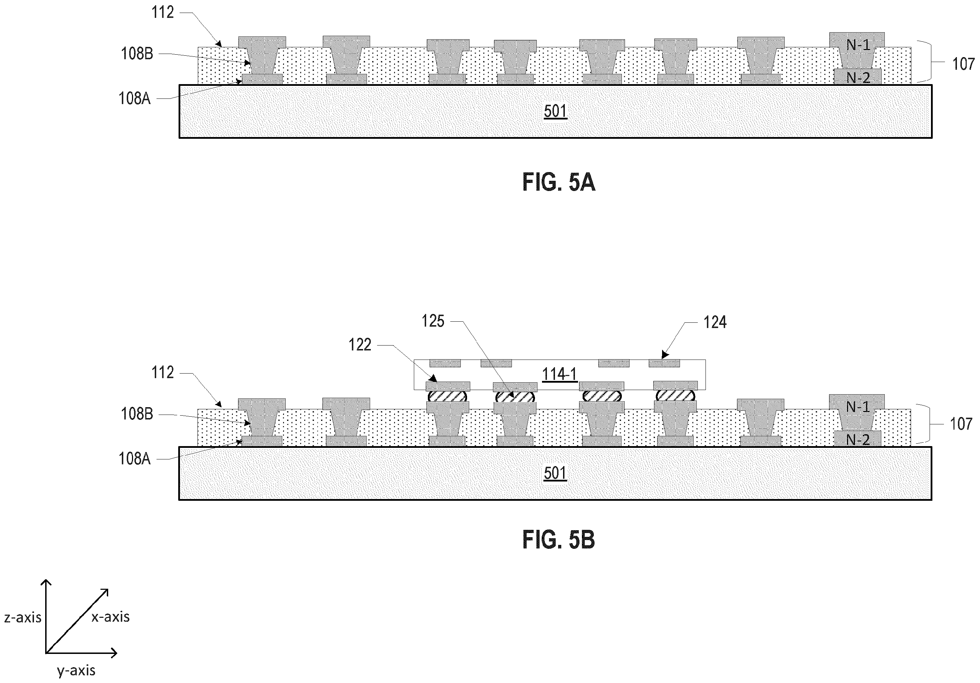

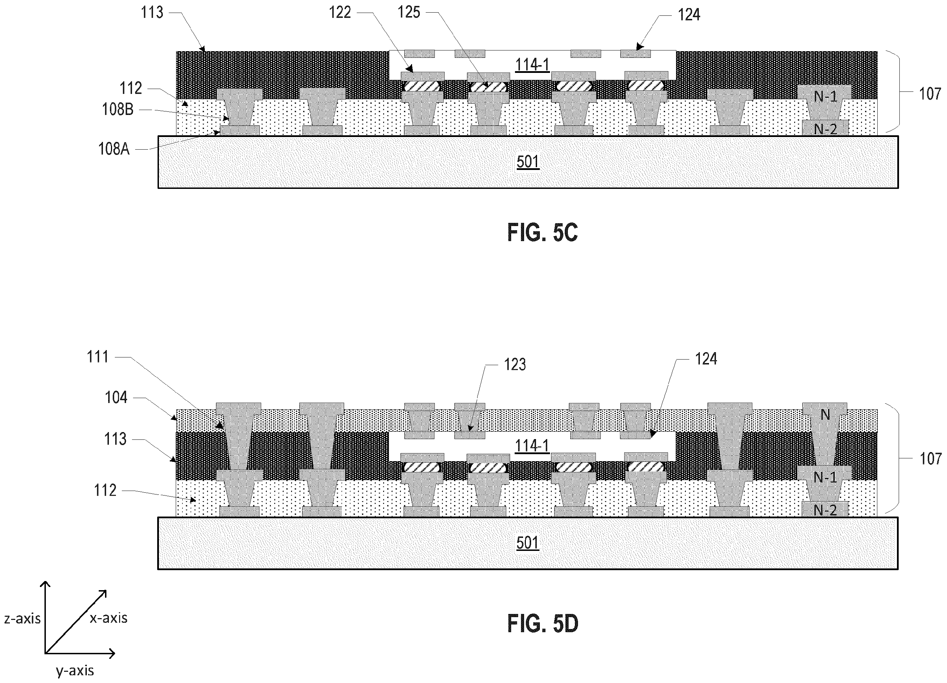

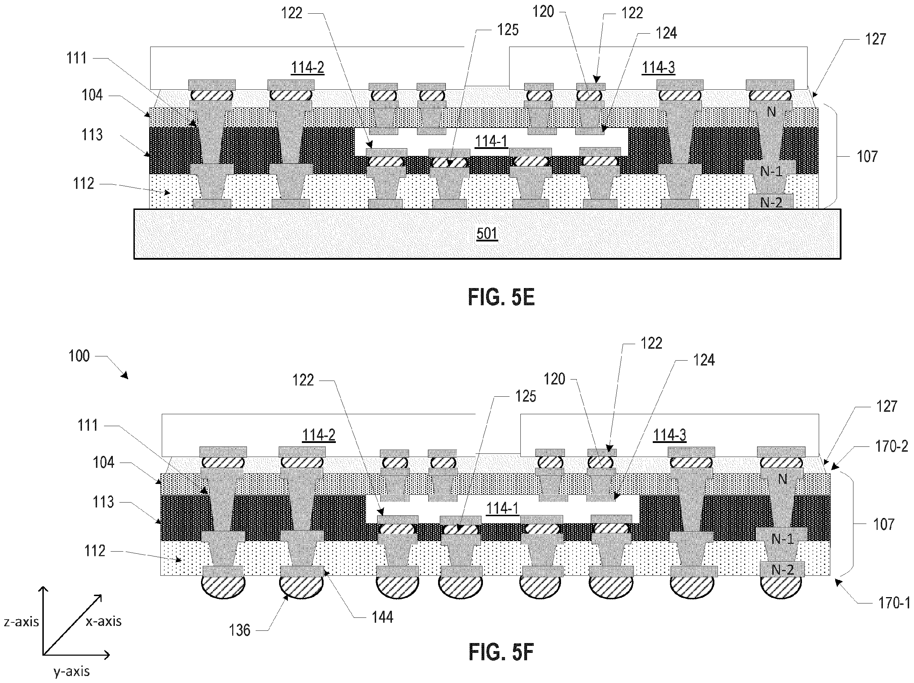

FIG. 2 is a schematic cross-sectional view of another example microelectronic assembly according to some embodiments of the present disclosure. The configuration of the embodiment shown in the figure is like that of FIG. 1A, except for differences as described further. The microelectronic assembly 100 may include a substrate 107 having a mold underfill material (MUF) 113 and a die 114-1 may be surrounded by the MUF material 113. The MUF material 113 may further surround the interconnects 125 (e.g., the MUF material 113 is between the bottom surface of the die 114-1 and the top surface of the dielectric material 112). The MUF material 113 may include a resin material with fillers, or an epoxy-based material with fillers. The MUF material 113 may have a thickness (e.g., a z-height) between 5 microns and 500 microns. As shown in FIG. 2, the MUF material 113 may surround the die 114-1 and may be around and in between interconnects 125. The MUF material 113 may be deposited using any suitable technique, for example, as described below with reference to FIG. 5. The microelectronic assembly 100 may further include conductive vias 111 through the MUF material 113 and the material 104 (e.g., vertical conductive pathways in the z-direction). The microelectronic assembly 100 of FIG. 2 further illustrates three layers (e.g., layer N, layer N-1, and layer N-2) and a single underfill material 127 between a bottom surface of the die 114-2, 114-3 and a top surface 170-2 of the substrate 107.

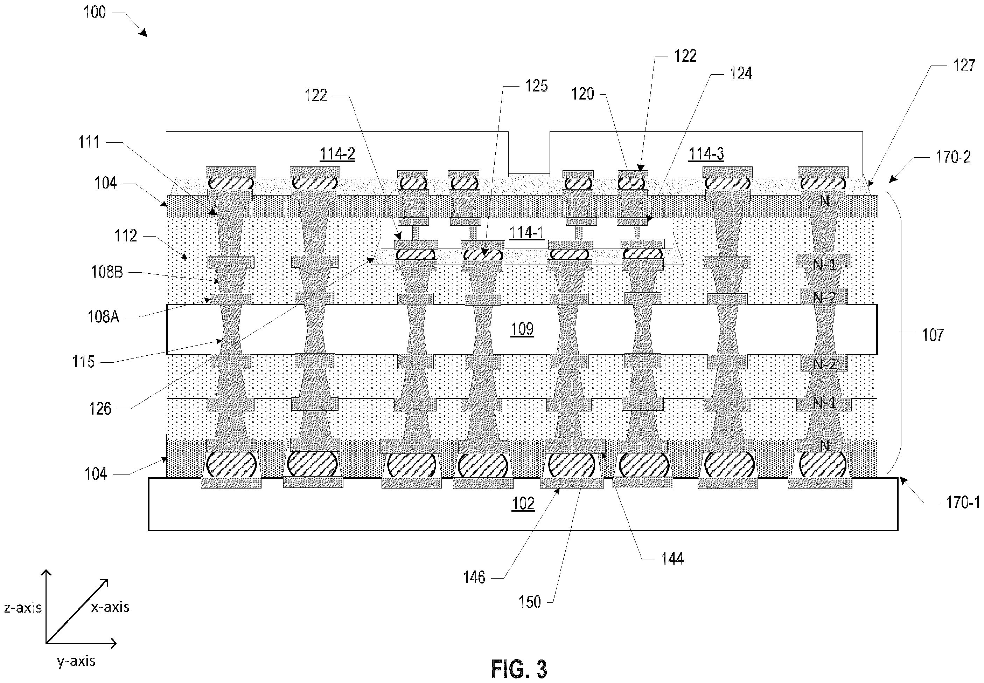

FIG. 3 is a schematic cross-sectional view of another example microelectronic assembly according to some embodiments of the present disclosure. The configuration of the embodiment shown in the figure is like that of FIG. 1A, except for differences as described further. The microelectronic assembly 100 may include a substrate 107 with a die 114-1 encapsulated in a dielectric material 112, where the die 114-1 is not within a cavity or conformally coated with the dielectric material 112A (e.g., as shown in FIG. 1). The microelectronic assembly 100 may further include conductive vias 111 through the dielectric material 112 and the material 104 (e.g., vertical conductive pathways in the z-direction).

### Example methods

Any suitable techniques may be used to manufacture the microelectronic assemblies 100 disclosed herein. For example, FIGS. 4A-4I are side, cross-sectional views of various stages in an example process for manufacturing the microelectronic assembly 100 of FIG. 1A, in accordance with various embodiments. Although the operations discussed below with reference to FIGS. 4A-4I (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 4A-4I may be modified in accordance with the present disclosure to fabricate others of microelectronic assembly 100 disclosed herein.

FIG. 4A illustrates an assembly that includes a portion of the substrate 107 (e.g., a preliminary substrate 107) including dielectric material 112 and patterned conductive material 108 on top and bottom surfaces of a core 109 having through-core vias 115. The patterned conductive material 108 may include at least N-2 metal layer with conductive traces 108A. In some embodiments, the substrate 107 may not include a core 109 and the preliminary substrate 107 may be formed directly on a carrier 401. The carrier 401 may include any suitable material for providing mechanical stability during manufacturing operations, and in some embodiments, may include a semiconductor wafer (e.g., a silicon wafer) or glass (e.g., a glass panel). The assembly of FIG. 4A may be manufactured using conventional package substrate manufacturing techniques (e.g., lamination of layers of the dielectric material 112, etc.). A top surface of the dielectric material 112 may be planarized using chemical mechanical polishing (CMP) or any other suitable process.

FIG. 4B illustrates an assembly subsequent to placing a die 114-1 on a top surface of the assembly of FIG. 4A and forming interconnects 125 between the conductive contacts 122 on a bottom surface of the die 114-1 and the conductive traces 108A in N-2 metal layer of the substrate 107. The die 114-1 may further include conductive contacts 124 on a top surface and TSVs (not shown). The die 114-1 may be placed using any suitable technique, for example, automated pick and place tooling. Interconnects 125 may include solder, such that the assembly may be subjected to a thermal reflow to form interconnects 125. For example, a thermal reflow process may include a thermal compression bonding (TCB) process with flux and then a deflux process after bonding to remove flux residue. Unlike manufacturing operations that embed a bridge die in a cavity, the TCB process may be used in this process because there are no space constraints for die placement and deflux.

FIG. 4C illustrates an assembly subsequent to dispensing an underfill material 126 around and between interconnects 125. The underfill material 126 may fully encapsulate individual interconnects 125 after curing.

FIG. 4D illustrates an assembly subsequent to removing the underfill material 126 that extends beyond a footprint of the die 114-1. The underfill material 126 may be removed using any suitable technique, for example, an excimer laser process. In some embodiments, the excess underfill material 126 may not be removed (e.g., as shown in FIG. 1A and as shown in subsequent FIGS. 4E-4I).

FIG. 4E illustrates an assembly subsequent to conformally coating the die 114-1 including the underfill material 126 with a dielectric material 112A. The dielectric material 112A may be deposited using any suitable technique, for example, slit coating, spray coating, jet dispense, or lamination, among others. In some embodiments, for example, when the die 114-1 is thin and the z-height differential between the top surface of the die 114-1 and the top surface of the dielectric material 112 of the portion of the substrate 107 is minimal, the dielectric material 112A may be conformally coated by vacuum lamination.

FIG. 4F illustrates an assembly subsequent to forming a next portion of the substrate 107 on a top surface of the assembly of FIG. 4E by forming a layer of dielectric material 112 and forming N-1 metal layer. The assembly of FIG. 4F may be manufactured using conventional package substrate manufacturing techniques.

FIG. 4G illustrates an assembly subsequent to forming a next portion of the substrate 107 on a top surface of the assembly of FIG. 4F by forming a layer of dielectric material 112 and forming N metal layer. The assembly of FIG. 4G may be manufactured using conventional package substrate manufacturing techniques. In some embodiments, a top surface of the dielectric material 112, 112A may be planarized using CMP or other suitable process.

FIG. 4H illustrates an assembly subsequent to forming a material 104 on a top surface of the assembly of FIG. 4G, forming via openings to expose the underlying conductive material 108 of the N metal layer and the conductive contacts 124 on atop surface of the die 114-1, depositing a conductive material in the via openings to form conductive vias 111. The material 104 may be deposited using any suitable techniques, including, for example, by lamination, spray coating, spin coating, or slit coating. The via openings may be formed using any suitable process, including lithography, laser drilling (e.g., laser ablation using excimer laser), or plasma etching. The via openings may have any suitable shape. For example, the via openings may have substantially vertical sidewalls to form rectangular-shaped vias or may have angled sidewalls to form conical-shaped vias, as shown. The shape of the via openings may depend on the process used to form the via openings (e.g., a lithographic process for rectangular-shaped vias and a laser drilling process for conical-shaped vias). The conductive material may include any suitable metal, such as copper, and may be deposited using any suitable technique, such as electrolytic plating.

FIG. 4I illustrates an assembly subsequent to electrically coupling die 114-2, 114-3 by interconnects 120 to a top surface of the assembly of FIG. 4H, depositing an underfill material 127, removing the carrier 401 from the assembly of FIG. 4H, forming a portion of the substrate 107 below the core 109, and depositing solder 136 on a bottom surface of conductive contacts 144. If multiple assemblies are manufactured together, the assemblies may be singulated. The assembly of FIG. 4I may itself be a microelectronic assembly 100, as shown. Further manufacturing operations may be performed on the microelectronic assembly 100 of FIG. 4I to form other microelectronic assembly 100; for example, attaching a circuit board 102 to a bottom surface of the microelectronic assembly 100 of FIG. 4I by forming interconnects 150, similar to FIG. 1A.

FIGS. 5A-5F are side, cross-sectional views of various stages in an example process for manufacturing a microelectronic assembly 100 that is similar to the microelectronic assembly 100 in FIG. 2, in accordance with various embodiments. FIG. 5A illustrates an assembly that includes a portion of the substrate 107 (e.g., a preliminary substrate 107) including dielectric material 112 and patterned conductive material 108 on top and bottom surfaces of a core 109 having through-core vias 115. The patterned conductive material 108 may include at least N-1 metal layer with conductive traces 108A. The preliminary substrate 107 does not include a core (e.g., the core 109 in FIG. 2) and is formed directly on a carrier 501. The carrier 501 may include any suitable material for providing mechanical stability during manufacturing operations, and in some embodiments, may include a semiconductor wafer (e.g., a silicon wafer) or glass (e.g., a glass panel). The assembly of FIG. 5A may be manufactured using conventional package substrate manufacturing techniques (e.g., lamination of layers of the dielectric material 112, etc.). A top surface of the dielectric material 112 may be planarized using chemical mechanical polishing (CMP) or any other suitable process.

FIG. 5B illustrates an assembly subsequent to placing a die 114-1 on a top surface of the assembly of FIG. 5A and forming interconnects 125 between the conductive contacts 122 on a bottom surface of the die 114-1 and the conductive traces 108A in N-1 metal layer of the substrate 107. The die 114-1 may further include conductive contacts 124 on a top surface and TSVs (not shown). The die 114-1 may be placed using any suitable technique, for example, automated pick and place tooling. Interconnects 125 may include solder, such that the assembly may be subjected to a thermal reflow to form interconnects 125. For example, a thermal reflow process may include a thermal compression bonding (TCB) process with flux and then a deflux process after bonding to remove flux residue. Unlike manufacturing operations that embed a bridge die in a cavity, the TCB process may be used in this process because there are no space constraints for die placement and deflux.

FIG. 5C illustrates an assembly subsequent to depositing a MUF material 113 on a top surface of the assembly of FIG. 5B, around the die 114-1, and around and between interconnects 125. The MUF material 113 may be deposited using any suitable technique, such as a compression molding process. The MUF material 113 may include any suitable material, as described above with reference to FIG. 2. In some embodiments, the MUF material 113 may be deposited over the top surface of the die 114-1 and may be removed and planarized by mechanical grinding or CMP. In some embodiments, the MUF material 113 may extend over the top surface of the die 114-1.

FIG. 5D illustrates an assembly subsequent to forming a material 104 on a top surface of the assembly of FIG. 5C and forming the N metal layer. The N metal layer may be formed by forming via openings to expose the underlying conductive material 108 of the N-1 metal layer and the conductive contacts 124 on atop surface of the die 114-1, and depositing a conductive material in the via openings to form conductive vias 111. The material 104 may be deposited using any suitable techniques, including, for example, by lamination, spray coating, spin coating, or slit coating. The via openings may be formed using any suitable process, including lithography, laser drilling (e.g., laser ablation using excimer laser), or plasma etching. The via openings may have any suitable shape. For example, the via openings may have substantially vertical sidewalls to form rectangular-shaped vias or may have angled sidewalls to form conical-shaped vias, as shown. The shape of the via openings may depend on the process used to form the via openings (e.g., a lithographic process for rectangular-shaped vias and a laser drilling process for conical-shaped vias). The conductive material may include any suitable metal, such as copper, and may be deposited using any suitable technique, such as electrolytic plating.

FIG. 5E illustrates an assembly subsequent to electrically coupling die 114-2, 114-3 by interconnects 120 to a top surface of the assembly of FIG. 5D and depositing an underfill material 127 around the interconnects 120.

FIG. 5F illustrates an assembly subsequent to removing the carrier 501 from the assembly of FIG. 5E and depositing solder 136 on a bottom surface of conductive contacts 144. If multiple assemblies are manufactured together, the assemblies may be singulated. The assembly of FIG. 5F may itself be a microelectronic assembly 100, as shown. Further manufacturing operations may be performed on the microelectronic assembly 100 of FIG. 5F to form other microelectronic assembly 100; for example, attaching a circuit board 102 to a bottom surface of the microelectronic assembly 100 of FIG. 5F by forming interconnects 150, similar to FIG. 1B.

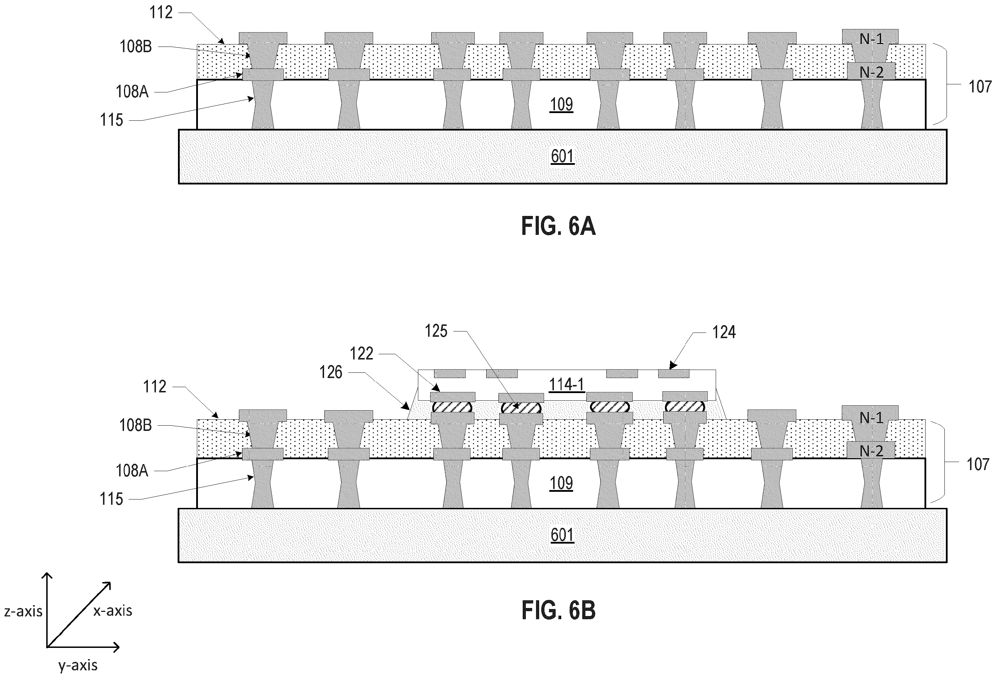

FIGS. 6A-6E are side, cross-sectional views of various stages in an example process for manufacturing a microelectronic assembly 100 of FIG. 3, in accordance with various embodiments. FIG. 6A illustrates an assembly that includes a portion of the substrate 107 (e.g., a preliminary substrate 107) including dielectric material 112 and patterned conductive material 108 on top and bottom surfaces of a core 109 having through-core vias 115. The patterned conductive material 108 may include at least N-2 metal layer with conductive traces 108A. In some embodiments, the substrate 107 may not include a core 109 and the preliminary substrate 107 may be formed directly on a carrier 601. The carrier 601 may include any suitable material for providing mechanical stability during manufacturing operations, and in some embodiments, may include a semiconductor wafer (e.g., a silicon wafer) or glass (e.g., a glass panel). The assembly of FIG. 6A may be manufactured using conventional package substrate manufacturing techniques (e.g., lamination of layers of the dielectric material 112, etc.). A top surface of the dielectric material 112 may be planarized using chemical mechanical polishing (CMP) or any other suitable process.

FIG. 6B illustrates an assembly subsequent to placing a die 114-1 on a top surface of the assembly of FIG. 4A, forming interconnects 125 between the conductive contacts 122 on a bottom surface of the die 114-1 and the conductive traces 108A in N-2 metal layer of the substrate 107, and dispensing an underfill material 126 around and between interconnects 125. The die 114-1 may further include conductive contacts 124 on a top surface and TSVs (not shown). The die 114-1 may be placed using any suitable technique, for example, automated pick and place tooling. Interconnects 125 may include solder, such that the assembly may be subjected to a thermal reflow to form interconnects 125. For example, a thermal reflow process may include a thermal compression bonding (TCB) process with flux and then a deflux process after bonding to remove flux residue. Unlike manufacturing operations that embed a bridge die in a cavity, the TCB process may be used in this process because there are no space constraints for die placement and deflux. The underfill material 126 may fully encapsulate individual interconnects 125 after curing. In some embodiments, the underfill material 126 that extends beyond a footprint of the die 114-1 may be removed, as described above with reference to FIG. 4D.

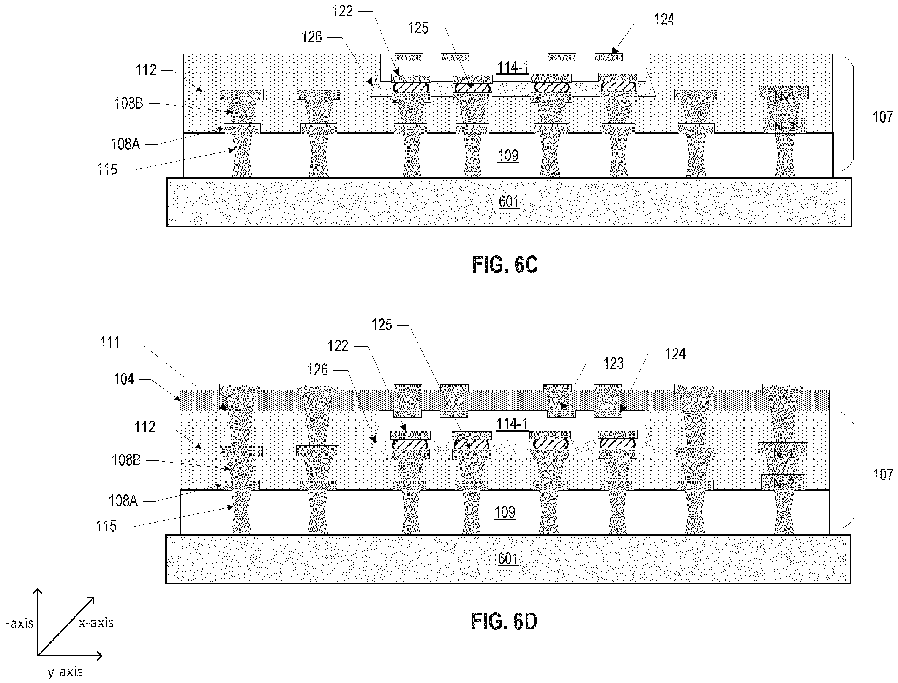

FIG. 6C illustrates an assembly subsequent to depositing a layer of dielectric material 112 on a top surface of the assembly of FIG. 6B, around the die 114-1, and the underfill material 126. The assembly of FIG. 4G may be manufactured using conventional package substrate manufacturing techniques, such as lamination. In some embodiments, the dielectric material 112 may be deposited over the top surface of the die 114-1 and may be removed and planarized by mechanical grinding or CMP.

FIG. 6D illustrates an assembly subsequent to forming a material 104 on a top surface of the assembly of FIG. 6C, forming via openings to expose the underlying conductive material 108 of the N-1 metal layer and the conductive contacts 124 on atop surface of the die 114-1, depositing a conductive material in the via openings to form conductive vias 111 to form the N metal layer. The material 104 may be deposited using any suitable techniques, including, for example, by lamination, spray coating, spin coating, or slit coating. The via openings may be formed using any suitable process, including lithography, laser drilling (e.g., laser ablation using excimer laser), or plasma etching. The via openings may have any suitable shape. For example, the via openings may have substantially vertical sidewalls to form rectangular-shaped vias or may have angled sidewalls to form conical-shaped vias, as shown. The shape of the via openings may depend on the process used to form the via openings (e.g., a lithographic process for rectangular-shaped vias and a laser drilling process for conical-shaped vias). The conductive material may include any suitable metal, such as copper, and may be deposited using any suitable technique, such as electrolytic plating.

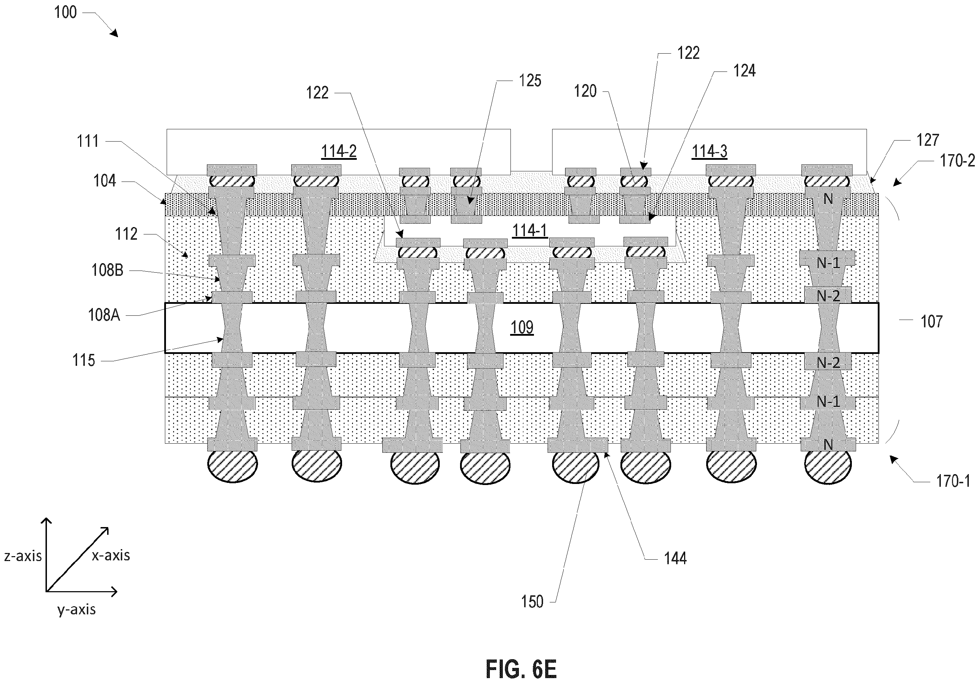

FIG. 6E illustrates an assembly subsequent to electrically coupling die 114-2, 114-3 by interconnects 120 to a top surface of the assembly of FIG. 6D, depositing an underfill material 127, removing the carrier 601 from the assembly of FIG. 6D, forming a portion of the substrate 107 below the core 109, and depositing solder 136 on a bottom surface of conductive contacts 144. If multiple assemblies are manufactured together, the assemblies may be singulated. The assembly of FIG. 6E may itself be a microelectronic assembly 100, as shown. Further manufacturing operations may be performed on the microelectronic assembly 100 of FIG. 6E to form other microelectronic assembly 100; for example, attaching a circuit board 102 to a bottom surface of the microelectronic assembly 100 of FIG. 6E by forming interconnects 150, similar to FIG. 3.

### Example devices and components

The microelectronic assemblies 100 disclosed herein may be included in any suitable electronic component. FIGS. 7-10 illustrate various examples of apparatuses that may include, or be included in, any of the microelectronic assemblies 100 disclosed herein.

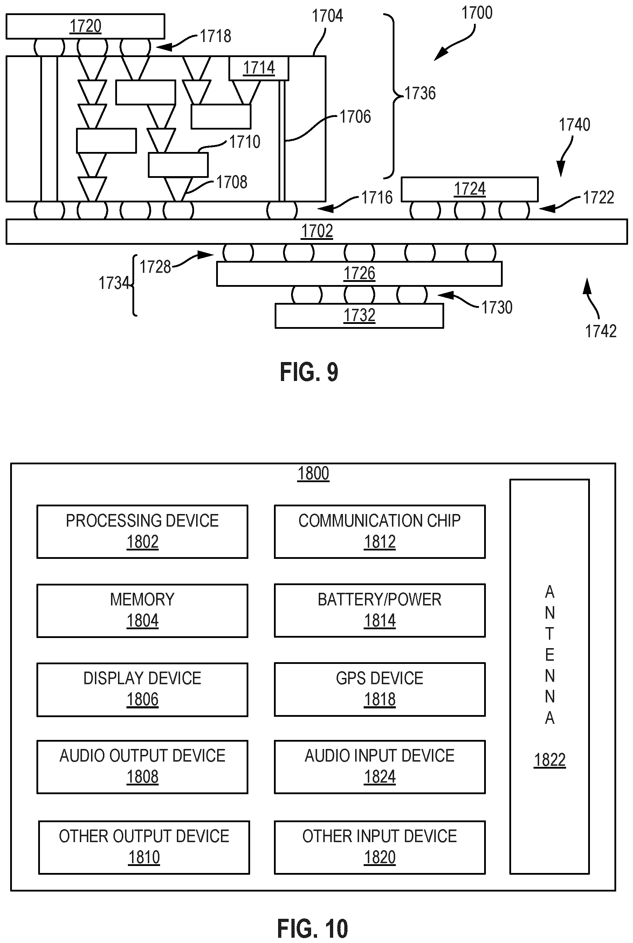

FIG. 7 is a top view of a wafer 1500 and dies 1502 that may be included in any of the microelectronic assemblies 100 disclosed herein (e.g., as any suitable ones of the dies 114). The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may be any of the dies 114 disclosed herein. The die 1502 may include one or more transistors (e.g., some of the transistors 1640 of FIG. 8, discussed below), supporting circuitry to route electrical signals to the transistors, passive components (e.g., signal traces, resistors, capacitors, or inductors), and/or any other IC components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 10) or other logic that is configured to store information in the memory devices or execute instructions stored in the memory array. In some embodiments, a die 1502 (e.g., a die 114) may be a central processing unit, a radio frequency chip, a power converter, or a network processor. Various ones of the microelectronic assemblies 100 disclosed herein may be manufactured using a die-to-wafer assembly technique in which some dies 114 are attached to a wafer 1500 that include others of the dies 114, and the wafer 1500 is subsequently singulated.

FIG. 8 is a cross-sectional side view of an IC device 1600 that may be included in any of the microelectronic assemblies 100 disclosed herein (e.g., in any of the dies 114). One or more of the IC devices 1600 may be included in one or more dies 1502 (FIG. 7). The IC device 1600 may be formed on a die substrate 1602 (e.g., the wafer 1500 of FIG. 7) and may be included in a die (e.g., the die 1502 of FIG. 7). The die substrate 1602 may be a semiconductor substrate composed of semiconductor material systems including, for example, n-type or p-type materials systems (or a combination of both). The die substrate 1602 may include, for example, a crystalline substrate formed using a bulk silicon or a silicon-on-insulator (SOI) substructure. In some embodiments, the die substrate 1602 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1602. Although a few examples of materials from which the die substrate 1602 may be formed are described here, any material that may serve as a foundation for an IC device 1600 may be used. The die substrate 1602 may be part of a singulated die (e.g., the dies 1502 of FIG. 7) or a wafer (e.g., the wafer 1500 of FIG. 7).

The IC device 1600 may include one or more device layers 1604 disposed on the die substrate 1602. The device layer 1604 may include features of one or more transistors 1640 (e.g., metal oxide semiconductor field-effect transistors (MOSFETs)) formed on the die substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 8 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a PMOS or a NMOS transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the die substrate 1602 and two sidewall portions that are substantially perpendicular to the top surface of the die substrate 1602. In other embodiments, at least one of the metal layers that form the gate electrode may simply be a planar layer that is substantially parallel to the top surface of the die substrate 1602 and does not include sidewall portions substantially perpendicular to the top surface of the die substrate 1602. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the die substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the die substrate 1602 to form the S/D regions 1620. An annealing process that activates the dopants and causes them to diffuse farther into the die substrate 1602 may follow the ion-implantation process. In the latter process, the die substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., transistors 1640) of the device layer 1604 through one or more interconnect layers disposed on the device layer 1604 (illustrated in FIG. 8 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs; in particular, the arrangement is not limited to the particular configuration of interconnect structures 1628 depicted in FIG. 8. Although a particular number of interconnect layers 1606-1610 is depicted in FIG. 8, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the die substrate 1602 upon which the device layer 1604 is formed. For example, the lines 1628a may route electrical signals in a direction in and out of the page from the perspective of FIG. 8. The vias 1628b may be arranged to route electrical signals in a direction of a plane that is substantially perpendicular to the surface of the die substrate 1602 upon which the device layer 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 8. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606-1610. In FIG. 8, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

In some embodiments in which the IC device 1600 is a double-sided die (e.g., like the die 114-1), the IC device 1600 may include another metallization stack (not shown) on the opposite side of the device layer(s) 1604. This metallization stack may include multiple interconnect layers as discussed above with reference to the interconnect layers 1606-1610, to provide conductive pathways (e.g., including conductive lines and vias) between the device layer(s) 1604 and additional conductive contacts (not shown) on the opposite side of the IC device 1600 from the conductive contacts 1636.

In other embodiments in which the IC device 1600 is a double-sided die (e.g., like the die 114-1), the IC device 1600 may include one or more TSVs through the die substrate 1602; these TSVs may make contact with the device layer(s) 1604, and may provide conductive pathways between the device layer(s) 1604 and additional conductive contacts (not shown) on the opposite side of the IC device 1600 from the conductive contacts 1636.

FIG. 9 is a cross-sectional side view of an IC device assembly 1700 that may include any of the microelectronic assemblies 100 disclosed herein. In some embodiments, the IC device assembly 1700 may be a microelectronic assembly 100. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any suitable ones of the embodiments of the microelectronic assemblies 100 disclosed herein.

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate. In some embodiments the circuit board 1702 may be, for example, a circuit board.

The IC device assembly 1700 illustrated in FIG. 9 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 9), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 9, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 7), an IC device (e.g., the IC device 1600 of FIG. 8), or any other suitable component. Generally, the interposer 1704 may spread a connection to a wider pitch or reroute a connection to a different connection. For example, the interposer 1704 may couple the IC package 1720 (e.g., a die) to a set of ball grid array (BGA) conductive contacts of the coupling components 1716 for coupling to the circuit board 1702. In the embodiment illustrated in FIG. 9, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

In some embodiments, the interposer 1704 may be formed as a PCB, including multiple metal layers separated from one another by layers of dielectric material and interconnected by electrically conductive vias. In some embodiments, the interposer 1704 may be formed of an epoxy resin, a fiberglass-reinforced epoxy resin, an epoxy resin with inorganic fillers, a ceramic material, or a polymer material such as polyimide. In some embodiments, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 9 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 10 is a block diagram of an example electrical device 1800 that may include one or more of the microelectronic assemblies 100 disclosed herein. For example, any suitable ones of the components of the electrical device 1800 may include one or more of the IC device assemblies 1700, IC devices 1600, or dies 1502 disclosed herein, and may be arranged in any of the microelectronic assemblies 100 disclosed herein. A number of components are illustrated in FIG. 10 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 10, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMLS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a computing device or a hand-held, portable or mobile computing device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server, or other networked computing component, a printer, a scanner, a monitor, a set-top box, an entertainment control unit, a vehicle control unit, a digital camera, a digital video recorder, or a wearable computing device. In some embodiments, the electrical device 1800 may be any other electronic device that processes data.

The following paragraphs provide various examples of the embodiments disclosed herein.

Example 1 is a microelectronic assembly, including a substrate including a material and conductive pathways through the material, the material includes an organic dielectric material; and a microelectronic component having a first surface and an opposing second surface, the first surface of the microelectronic component is electrically coupled to the conductive pathways in the material by interconnects, the interconnects include solder and are surrounded by a capillary underfill material, and the microelectronic component and the capillary underfill material are surrounded by the material of the substrate.

Example 2 may include the subject matter of Example 1, and may further specify that the organic dielectric material includes a buildup material, a polyimide, a polyamide, a polyacrylate, an epoxy, a polybenzoxazole, a polyphenyl ether, a polysiloxane, a polynorbornene, a polyolefin, or a photoimageable polymer.

Example 3 may include the subject matter of Example 1 or 2, and may further specify that the material includes multiple organic dielectric materials.

Example 4 may include the subject matter of Example 1 or 2, and may further specify that the material includes a first organic dielectric material and a second organic dielectric material different than the first organic dielectric organic material, and the second organic dielectric material surrounds the microelectronic component and the capillary underfill material, and is between the microelectronic component and the capillary underfill material, and the first organic dielectric material.

Example 5 may include the subject matter of any of Examples 1-4, and may further specify that the interconnects have a pitch between 25 microns and 250 microns.

Example 6 may include the subject matter of any of Examples 1-5, and may further specify that the interconnects do not include a non-conductive film.

Example 7 may include the subject matter of any of Examples 1-6, and may further specify that the microelectronic component is a first microelectronic component, and the interconnects are first interconnects, and the microelectronic assembly may further include a second microelectronic component electrically coupled to the second surface of the first microelectronic component by second interconnects, the second interconnects including solder.

Example 8 may include the subject matter of Example 7, and may further specify that the second interconnects have a pitch between 25 microns and 250 microns.

Example 9 may include the subject matter of any of Examples 1-8, and may further specify that the conductive pathways include conductive traces that are parallel to the first and second surfaces of the microelectronic component and extend through the material along a side surface of the microelectronic component.

Example 10 may include the subject matter of any of Examples 1-9, and may further specify that the substrate further includes a core; and a conductive via, through the core, electrically coupled to the microelectronic component by the conductive pathways through the material.

Example 11 may include the subject matter of any of Examples 1-10, and may further specify that the substrate includes a third surface and an opposing fourth surface, and the microelectronic assembly may further include a circuit board electrically coupled to the third surface of the substrate.

Example 12 is a microelectronic assembly, including a first layer of a substrate including a first material and first conductive pathways through the first material, the first material including an organic dielectric material; a second layer of the substrate on the first layer, the second layer including a second material and second conductive pathways through the second material, the second material including a mold underfill material; and a microelectronic component having a first surface and an opposing second surface, the microelectronic component is in the second layer of the substrate, the first surface of the microelectronic component is electrically coupled to the first conductive pathways in the first layer by interconnects including solder, and the microelectronic component and the interconnects are surrounded by the second material.

Example 13 may include the subject matter of Example 12, and may further specify that the interconnects have a pitch between 25 microns and 250 microns.

Example 14 may include the subject matter of Example 12 or 13, and may further specify that the interconnects do not include a non-conductive film.

Example 15 may include the subject matter of any of Examples 12-14, and may further specify that the microelectronic component is a first microelectronic component, and the interconnects are first interconnects, and the microelectronic assembly may further include a second microelectronic component electrically coupled to the second surface of the first microelectronic component by second interconnects, the second interconnects including solder.

Example 16 may include the subject matter of Example 15, and may further specify that the second interconnects have a pitch between 25 microns and 250 microns.

Example 17 may include the subject matter of any of Examples 12-16, and may further specify that the first conductive pathways include conductive vias and conductive traces, and the second conductive pathways include conductive vias and not conductive traces.

Example 18 may include the subject matter of any of Examples 12-17, and may further specify that the substrate further includes a core; and a conductive via, through the core, electrically coupled to the microelectronic component by the first conductive pathways through the first material.

Example 19 may include the subject matter of any of Examples 12-18, and may further include a circuit board electrically coupled to the first layer of the substrate.

Example 20 is a microelectronic assembly, including a first layer of a substrate including a material and first conductive pathways through the material, the material including an organic dielectric material; a second layer of the substrate on the first layer, the second layer including the material and second conductive pathways through the material; and a microelectronic component having a first surface and an opposing second surface, the microelectronic component is in the second layer of the substrate, the first surface of the microelectronic component is electrically coupled to the first conductive pathways in the first layer by interconnects, the interconnects include solder and are surrounded by a capillary underfill material, and the microelectronic component and the capillary underfill material are surrounded by the material.

Example 21 may include the subject matter of Example 20, and may further specify that the interconnects have a pitch between 25 microns and 250 microns.

Example 22 may include the subject matter of Example 20 or 21, and may further specify that the interconnects do not include a non-conductive film.

Example 23 may include the subject matter of any of Examples 20-22, and may further specify that the microelectronic component is a first microelectronic component, and the interconnects are first interconnects, and the microelectronic assembly may further include a second microelectronic component electrically coupled to the second surface of the first microelectronic component by second interconnects, the second interconnects including solder.

Example 24 may include the subject matter of Example 23, and may further specify that the second interconnects have a pitch between 25 microns and 250 microns.

Example 25 may include the subject matter of any of Examples 20-24, and may further specify that the first conductive pathways include conductive vias and conductive traces, and the second conductive pathways include conductive vias and not conductive traces.

Example 26 may include the subject matter of any of Examples 20-25, and may further specify that the substrate further includes a core; and a conductive via, through the core, electrically coupled to the microelectronic component by the first conductive pathways through the material.

Example 27 may include the subject matter of any of Examples 20-26, and may further include a circuit board electrically coupled to the first layer of the substrate by third interconnects.

Example 28 may include the subject matter of Example 27, and may further specify that a pitch of the third interconnects is between 55 microns and 2000 microns.

Example 29 may include the subject matter of any of Examples 20-28, and may further specify that the material includes multiple organic dielectric materials.

Example 30 may include the subject matter of any of Examples 20-29, and may further specify that the microelectronic component includes a semiconductor die.

## Claims

1. A microelectronic assembly, comprising:
a substrate including a material and conductive pathways through the material, wherein the material includes an organic dielectric material; and
a microelectronic component having a first surface and an opposing second surface, wherein the first surface of the microelectronic component is electrically coupled to the conductive pathways in the material by interconnects, wherein the interconnects include solder and are surrounded by a capillary underfill material, and wherein the microelectronic component and the capillary underfill material are surrounded by the material of the substrate.

2. The microelectronic assembly of claim 1, wherein the organic dielectric material includes a buildup material, a polyimide, a polyamide, a polyacrylate, an epoxy, a polybenzoxazole, a polyphenyl ether, a polysiloxane, a polynorbornene, a polyolefin, or a photoimageable polymer.

3. The microelectronic assembly of claim 1 or 2, wherein the material includes multiple organic dielectric materials.

4. The microelectronic assembly of any one of claims 1-3, wherein the material includes a first organic dielectric material and a second organic dielectric material different than the first organic dielectric organic material, and wherein the second organic dielectric material surrounds the microelectronic component and the capillary underfill material, and is between the microelectronic component and the capillary underfill material, and the first organic dielectric material.

5. The microelectronic assembly of any one of claims 1-4, wherein the conductive pathways include conductive traces that are parallel to the first and second surfaces of the microelectronic component and extend through the material along a side surface of the microelectronic component.

6. A microelectronic assembly, comprising:
a first layer of a substrate including a first material and first conductive pathways through the first material, the first material including an organic dielectric material;
a second layer of the substrate on the first layer, the second layer including a second material and second conductive pathways through the second material, the second material including a mold underfill material; and
a microelectronic component having a first surface and an opposing second surface, wherein the microelectronic component is in the second layer of the substrate, wherein the first surface of the microelectronic component is electrically coupled to the first conductive pathways in the first layer by interconnects including solder, and wherein the microelectronic component and the interconnects are surrounded by the second material.

7. The microelectronic assembly of claim 6, wherein the first conductive pathways include conductive vias and conductive traces, and the second conductive pathways include conductive vias and not conductive traces.

8. A microelectronic assembly, comprising:
a first layer of a substrate including a material and first conductive pathways through the material, the material including an organic dielectric material;
a second layer of the substrate on the first layer, the second layer including the material and second conductive pathways through the material; and
a microelectronic component having a first surface and an opposing second surface, wherein the microelectronic component is in the second layer of the substrate, wherein the first surface of the microelectronic component is electrically coupled to the first conductive pathways in the first layer by interconnects, wherein the interconnects include solder and are surrounded by a capillary underfill material, and wherein the microelectronic component and the capillary underfill material are surrounded by the material.

9. The microelectronic assembly of claim 8, wherein the first conductive pathways include conductive vias and conductive traces, and the second conductive pathways include conductive vias and not conductive traces.

10. The microelectronic assembly of any one of the preceding claims, wherein the interconnects have a pitch between 25 microns and 250 microns.

11. The microelectronic assembly of any one of the preceding claims, wherein the interconnects do not include a non-conductive film.

12. The microelectronic assembly of any one of the preceding claims, wherein the microelectronic component includes a semiconductor die.

13. The microelectronic assembly of any one of the preceding claims, wherein the substrate further comprises:
a core; and
a conductive via, through the core, electrically coupled to the microelectronic component by the first conductive pathways through the first material.

14. The microelectronic assembly of any one of the preceding claims, wherein the microelectronic component is a first microelectronic component, and wherein the interconnects are first interconnects, and the microelectronic assembly further comprising:
a second microelectronic component electrically coupled to the second surface of the first microelectronic component by second interconnects, the second interconnects including solder.

15. The microelectronic assembly of claim 14, wherein the second interconnects have a pitch between 25 microns and 250 microns.
